# EUROPÄISCHE PATENTANMELDUNG

(11) **EP 2 878 619 A1**
(43) Veröffentlichungstag der Anmeldung: **03.06.2015**
(21) Anmeldenummer: 13195325.9
(22) Anmeldetag: 02.12.2013
(51) Int. Cl.: C08K 3/34, C08L 67/00, H01L 33/64

(54) **Polyester Zusammensetzungen**

(71) Anmelder: LANXESS Deutschland GmbH, 50569 Köln (DE)
(72) Erfinder: Immel, Timo, 41539 Dormagen (DE); Endtner, Jochen, 50679 Köln (DE); Bienmüller, Matthias, 47803 Krefeld (DE); Benighaus, Tobias, 40215 Düsseldorf (DE); Plutowski, Ulrich, 41539 Dormagen (DE)

(57) **Zusammenfassung**

Die vorliegende Erfindung betrifft Zusammensetzungen auf Basis von Polyestern mit dem mineralischen Füllstoff Aluminiumsilikat, insbesondere mit triklin-pinakoidaler Kristallstruktur, deren Herstellung, sowie die Verwendung dieser Zusammensetzungen in Formmassen für den Spritzguss oder in der Extrusion zur Herstellung elektrisch isolierender, thermisch leitfähiger Erzeugnisse bevorzugt zur Herstellung von Kühlkörpern, insbesondere von Kühlkörpern für Licht emittierende Dioden (LEDs).

## Beschreibung

Die vorliegende Erfindung Zusammensetzungen auf Basis von Polyestern mit dem mineralischen Füllstoff Aluminiumsilikat, insbesondere mit triklin-pinakoidaler Kristallstruktur, deren Herstellung, sowie die Verwendung dieser Zusammensetzungen in Formmassen für den Spritzguss oder in der Extrusion zur Herstellung elektrisch isolierender, thermisch leitfähiger Erzeugnisse bevorzugt zur Herstellung von Kühlkörpern, insbesondere von Kühlkörpern für Licht emittierende Dioden (LEDs).

Thermoplastische Polymere werden wegen ihrer guten elektrisch isolierenden Eigenschaften für zahlreiche Anwendungen in der Elektroindustrie eingesetzt. Sie wirken aufgrund ihrer geringen Wärmeleitfähigkeit aber auch thermisch isolierend, was beim Einsatz für elektrische Bauteile dann ein Problem darstellt, wenn relativ viel Wärme entsteht, die abgeführt werden muss. So wird beispielsweise bei LEDs nur ein Anteil im Bereich von etwa 20 bis 30% der aufgenommenen elektrischen Energie in Licht umgewandelt, der Rest fällt als Verlustwärme an. Gegenüber Leuchten mit herkommlichen Lampen ist die Ableitung dieser Verlustwärme sehr viel schwieriger. Einerseits muss die Temperatur der LEDs möglichst niedrig gehalten werden, weil sonst der Wirkungsgrad und die Lebensdauer beeinträchtigt werden. Andererseits ermöglichen LEDs auch eine besonders kleine Bauweise und strahlen so gut wie keine Wärme ab, so dass die Wärmeabfuhr zunächst vor allem durch Wärmeleitung erfolgen muss.

Heute werden zur Entwärmung von LEDs typischerweise metallische Kühlkörper, meist aus Aluminium oder Kupfer eingesetzt. Nachteilig an diesen Kühlkörpern ist zum einen die hohe spezifische Dichte der metallischen Werkstoffe und das Metall-bedingte zwangsläufig hohe Bauteilgewicht. Des Weiteren ist die elektrische Leitfähigkeit des Metalls und die damit einhergehende Gefahr eines Kurzschlusses von Nachteil. Eine Lösung hierfür bieten elektrisch isolierende Kühlkörper aus wärmeleitenden Kunststoffen.

Die Verwendung wärmeleitender Kunststoffe als Kühlkörper zur Entwärmung von elektronischen Bauteilen (DE 10 2007 057 533 A1) und insbesondere auch deren Verwendung bei der Entwärmung von LEDs (DE 10 2011 077 668 A1 und US2012/0307501 A1) ist bekannt.

Polymere sind von Natur aus nur schlecht wärmeleitfähig. Um eine beispielsweise für die Verwendung in LED-Kühlkörpern nötige Wärmeleitfähigkeit zu erreichen, werden den für die Herstellung von Kühlkörpern einzusetzenden Polymer-basierten Formmassen wärmeleitfähige Additive zugesetzt.

In JP 2007 016093 A wird eine Zusammensetzung aus thermoplastischen Polymeren und 1-50 Gew.- % Graphit mit verbesserter thermischer Leitfähigkeit von 1,6 W/mK beschrieben.

Insbesondere für die Verwendung in LED Kühlkörpern beschreibt US 2012/0319031 A1 die Verwendung von thermoplastischen Formmassen mit 10 bis 70 Gew.-% Graphit.

Durch die Verwendung von Graphit wird die Eigenschaft des Kunststoffes als elektrischer Isolator jedoch deutlich beeinträchtigt. Um diesen Nachteil zu umgehen, werden in der US 2012/0319031 A1 wiederum anorganische Additive zur Verbesserung der Wärmeleitfähigkeit zugegeben.

In DE 102 60 098 A1 und WO 08/043682 A1 wird gezeigt, dass thermoplastische Polyester durch Zusatz von Aluminiumoxid elektrisch isolierend und wärmeleitfähig sind. Als weitere Zusatzstoffe werden niedermolekulare und polymere organische Verbindungen aufgeführt.

Allerdings führt der Einsatz von Aluminiumoxid in der Verarbeitung von Polyester Compounds zu einer verstärkten Abnutzung der eingesetzten Geräte infolge der Härte des Aluminiumoxids. Im Falle der Extrusion Aluminiumoxid-basierter Formmassen sind besonders Schnecke, Schneckengehäuse und Düse von verstärkter Abnutzung betroffen. Bei einer Verarbeitung im Spritzgussprozess wird zusätzlich die Abnutzung der Spritzgussform deutlich erhöht.

Eine Lösung des durch Aluminiumoxid verursachten Problems der verstärkten Abnutzung an einzusetzenden Geräten zeigt EP 2 078 736 A1. Hier wird die Verwendung thermoplastischer Formmassen, bevorzugt auf Basis von Polyestern, mit Bornitrid als wärmeleitfähigem Additiv beschrieben. Allerdings ist die Wärmeleitfähigkeit von Bornitrid aufgrund der Anisotrophie von Bornitrid richtungsabhängig. Hohe Wärmeleitfähigkeiten von mehr als 2 W/mK werden typischer Weise nur in Spritzrichtung erreicht. Des Weiteren erschwert die Anisotropie des Bornitrids die Simulation der Wärmeleitfähigkeit im Bauteil enorm, da die Ausrichtung der Füllstoffteilchen in der abgekühlten Formmasse mit simuliert werden muss.

Aufgabe der vorliegenden Erfindung war deshalb die Bereitstellung thermoplastischer Formmassen auf Basis von Polyestern zur Herstellung elektrisch isolierender, thermisch leitfähiger Erzeugnisse bevorzugt von Kühlkörpern, insbesondere von Kühlkörpern für Licht emittierende Dioden (LEDs). Diese sollen eine hohe isotrope Wärmeleitfähigkeit und insbesondere eine hohe Wärmeleitfähigkeit auch orthogonal zur Spritzrichtung bei gleichzeitig guten mechanischen Eigenschaften aufweisen. Des Weiteren sollen die oben genannten Nachteile, die mit dem Einsatz von Aluminiumoxid oder Graphit einhergehen, vermieden werden.

Überraschenderweise wurde gefunden, dass thermoplastische Formmassen auf Basis von Polyestern die Aluminiumsilikat, bevorzugt mit triklin-pinakoidaler Kristallstruktur in Form des Minerals Kyanit enthalten, sich durch ihre hohe Wärmeleitfähigkeit auch orthogonal zur Spritzrichtung und durch gute mechanische Eigenschaften hervorragend zur Herstellung elektrisch isolierender, thermisch leitfähiger Erzeugnisse, bevorzugt von Kühlkörpern, insbesondere von Kühlkörpern für Licht emittierende Dioden (LEDs), eignen.

Lösung der Aufgabe und somit Gegenstand der Erfindung sind deshalb Zusammensetzungen enthaltend
a) 15 bis 70 Gew.-%, bevorzugt 15 bis 50 Gew.-%, besonders bevorzugt 20 bis 40 Gew.-%, wenigstens eines Polyesters, bevorzugt PBT, PET oder PCT oder Blends aus beliebigen Kombinationen dieser, besonders bevorzugt Blends aus PBT und PET worin der Anteil an PET bezogen auf die Summe aller enthaltenen Polyester im Bereich von 50 bis 99,9 Gew-% liegt,
b) 29 bis 84 Gew.-% Aluminiumsilikat, bevorzugt 45 bis 80 Gew.-% Aluminiumsilikat, besonders bevorzugt 55 bis 75 Gew.-% Aluminiumsilikat, und gegebenenfalls
c) 0,01 bis 15 Gew.-%, bevorzugt 0,01 bis 10 Gew.-%, besonders bevorzugt 0,01 bis 5 Gew.-% Talkum, bevorzugt mikrokristallines Talkum, wobei die Summe aller Gewichtsprozente stets 100 ergibt.

Zur Klarstellung sei angemerkt, dass vom Rahmen der vorliegenden Erfindung alle nachfolgend aufgeführten allgemeinen oder in Vorzugsbereichen genannten Definitionen und Parameter in beliebigen Kombinationen umfasst sind.

Gegenstand der Erfindung sind also einerseits Zusammensetzungen enthaltend
a) 15 bis 70 Gew.-%, bevorzugt 15 bis 50 Gew.-%, besonders bevorzugt 20 bis 40 Gew.-%, wenigstens eines Polyesters, bevorzugt PBT, PET oder PCT oder Blends aus beliebigen Kombinationen dieser, besonders bevorzugt Blends aus PBT und PET worin der Anteil an PET bezogen auf die Summe aller enthaltenen Polyester im Bereich von 50 bis 99,9 Gew-% liegt und
b) 29 bis 84 Gew.-% Aluminiumsilikat, bevorzugt 45 bis 80 Gew.-% Aluminiumsilikat, besonders bevorzugt 55 bis 75 Gew.-% Aluminiumsilikat, wobei die Summe aller Gewichtsprozente stets 100 ergibt und diese Zusammensetzungen weitere Zusatzsstoffe gemäß der Komponenten d) bis h) enthalten können.

Gegenstand der Erfindung sind andererseits Zusammensetzungen enthaltend
a) 15 bis 70 Gew.-%, bevorzugt 15 bis 50 Gew.-%, besonders bevorzugt 20 bis 40 Gew.-%, wenigstens eines Polyesters, bevorzugt PBT, PET oder PCT oder Blends aus beliebigen Kombinationen dieser, besonders bevorzugt Blends aus PBT und PET worin der Anteil an PET bezogen auf die Summe aller enthaltenen Polyester im Bereich von 50 bis 99,9 Gew-% liegt,
b) 29 bis 84 Gew.-% Aluminiumsilikat, bevorzugt 45 bis 80 Gew.-% Aluminiumsilikat, besonders bevorzugt 55 bis 75 Gew.-% Aluminiumsilikat, und
c) 0,01 bis 15 Gew.-%, bevorzugt 0,01 bis 10 Gew.-%, besonders bevorzugt 0,01 bis 5 Gew.-% Talkum, bevorzugt mikrokristallines Talkum, wobei die Summe aller Gewichtsprozente stets 100 ergibt und auch diese Zusammensetzungen weitere Zusatzstoffe der Komponenten d) bis h) enthalten können.

Gute mechanische Eigenschaften im Sinne der vorliegenden Erfindung zeichnen sich im Falle herzustellender Erzeugnisse durch hohe Werte bei der Izod Schlagzähigkeit und gleichzeitig hohen Werten oder zumindest Beibehaltung der Eigenschaften in Bezug auf Randfaserdehnung gegenüber dem Stand der Technik aus.

Die Schlagzähigkeit beschreibt die Fähigkeit eines Werkstoffes Stoßenergie und Schlagenergie zu absorbieren ohne zu brechen. Die Prüfung der Izod Schlagzähigkeit nach ISO 180 ist eine Standard-Methode zur Bestimmung der Schlagzähigkeit von Materialien. Hierbei wird ein Arm zunächst in einer bestimmten Höhe gehalten (= konstante potentielle Energie) und schließlich freigegeben. Der Arm trifft auf die Probe wobei diese bricht. Von der Energie, die durch die Probe absorbiert wird, wird die Aufprallenergie bestimmt. Die Schlagzähigkeit wird berechnet als das Verhältnis aus Schlagarbeit und Probekörperquerschnitt (Maßeinheit kJ/m²).

Die Randfaserdehnung wird im Kurzzeit-Biegeversuch nach ISO 178 bestimmt. Hierzu werden balkenförmige Probekörper vorzugsweise mit den Abmessungen 80 mm · 10 mm · 4 mm an den Enden auf zwei Aufleger gelegt und in der Mitte mit einem Biegestempel belastet. Aus den ermittelten Kräften und Durchbiegungen werden die Kennwerte für die Randfaserdehnung errechnet. (Bodo Carlowitz: Tabellarische Übersicht über die Prüfung von Kunststoffen, 6. Auflage, Giesel-Verlag für Publizität, 1992, S. 16-17)

In einer bevorzugten Ausführungsform enthalten die erfindungsgemäßen Zusammensetzungen zusätzlich zu den Komponenten a) bis c) noch
d) 0,01 bis 5 Gew.-%, bevorzugt 0,05 bis 4 Gew.-%, besonders bevorzugt 0,1 bis 3 Gew.-% wenigstens eines Phosphitstabilisators, wobei die Komponenten a, b, c) soweit reduziert werden, dass die Summe aller Gewichtsprozente stets 100 ergibt.

In einer bevorzugten Ausführungsform betrifft die vorliegende Erfindung Zusammensetzungen enthaltend zusätzlich zu den Komponenten a) bis d) oder anstelle von d) noch
e) 0,01 bis 10 Gew.% wenigstens eines Additives zur Verbesserung der Fließfähigkeit, auch als Fließhilfsmittel, Fließmittel, Fließhilfe oder inneres Gleitmittel bezeichnet, wobei die übrigen Komponenten soweit reduziert werden, dass die Summe aller Gewichtsprozente stets 100 ergibt.

In einer bevorzugten Ausführungsform enthalten die erfindungsgemäßen Zusammensetzungen zusätzlich zu den Komponenten a) bis d) oder anstelle von d) und/oder e) noch
f) 0,01 bis 3 Gew.%, bevorzugt 0,1 bis 2 Gew.-%, besonders bevorzugt 0,5 bis 1 Gew.-% wenigstens einer Form von Ruß eingesetzt, wobei die übrigen Komponenten soweit reduziert werden, dass die Summe aller Gewichtsprozente stets 100 ergibt.

In einer bevorzugten Ausführungsform enthalten die erfindungsgemäßen Zusammensetzungen zusätzlich zu den Komponenten a) bis e) oder anstelle der Komponenten d) und/oder e) und/oder f) noch
g) 0,01 bis 15 Gew.-%, bevorzugt 0,01 bis 10 Gew.-%, besonders bevorzugt 0,01 bis 5 Gew.-% wenigstens eines Entformungsmittels, wobei die übrigen Komponenten soweit reduziert werden, dass die Summe aller Gewichtsprozente stets 100 ergibt.

In einer bevorzugten Ausführungsform enthalten die erfindungsgemäßen Zusammensetzungen zusätzlich zu den Komponenten a) bis g) oder anstelle der Komponenten d) und/oder e) und/oder f) und/oder g) noch
h) 0,01 bis 45 Gew.-%, bevorzugt 0,01 bis 30 Gew.-%, besonders bevorzugt 0,01 bis 15 Gew.-% wenigstens eines sonstigen, zu den Komponenten c) bis g) oder anstelle der Komponenten d) und/oder e) und/oder f) und/oder g) unterschiedlichen Additivs, wobei die übrigen Komponenten soweit reduziert werden, dass die Summe aller Gewichtsprozente stets 100 ergibt.

Erfindungsgemäß wird als Komponente a) wenigstens ein Polyester eingesetzt, bevorzugt wenigstens ein Polyalkylenterephthalat oder Polycycloalkylenterephthalat, besonders bevorzugt wenigstens ein Polyester der Gruppe Polybutylenterephthalat (PBT), Polyethylenterephthalat (PET), Poly(1,4-cyclohexandimethanolterephthalat (PCT), oder ein Blend auf Basis von PBT und PET, oder ein Blend auf Basis von PBT und PCT, oder ein Blend auf Basis von PET und PCT oder ein Blend auf Basis von PBT, PET und PCT. Ganz besonders bevorzugte Blends sind aus PBT und PET worin der Anteil an PET bezogen auf die Summe aller enthaltenen Polyester im Bereich von 50 bis 99,9 Gew-% liegt.

Die erfindungsgemäß einzusetzenden Polyester sind Reaktionsprodukte aus aromatischen Dicarbonsäuren oder ihren reaktionsfähigen Derivaten, bevorzugt Dimethylestern oder Anhydriden, und aliphatischen, cycloaliphatischen oder araliphatischen Diolen und Mischungen dieser Edukte. Sie lassen sich aus Terephthalsäure (oder ihren reaktionsfähigen Derivaten) und den jeweiligen aliphatischen Diolen mit 2 bzw. 4 C-Atomen bzw. dem cycloaliphatischen 1,4-Bis(hydroxymethyl)-cyclohexan nach bekannten Methoden herstellen (Kunststoff-Handbuch, Bd. VIII, S. 695 FF, Karl-Hanser-Verlag, München 1973).

Bevorzugt als Polyester einzusetzendes PET enthält mindestens 80 Mol-%, vorzugsweise mindestens 90 Mol-%, bezogen auf die Dicarbonsäure, Terephthalsäurereste und mindestens 80 Mol-%, vorzugsweise mindestens 90 Mol-%, bezogen auf die Diolkomponente, Ethylenglykolreste.

Bevorzugt als Polyester einzusetzendes PBT enthält mindestens 80 Mol-%, vorzugsweise mindestens 90 Mol-%, bezogen auf die Dicarbonsäure, Terephthalsäurereste und mindestens 80 Mol-%, vorzugsweise mindestens 90 Mol-%, bezogen auf die Diolkomponente, Butandiol-1,4-glykolreste.

Bevorzugt als Polyester einzusetzendes PCT enthält mindestens 80 Mol-%, vorzugsweise mindestens 90 Mol-%, bezogen auf die Dicarbonsäure, Terephthalsäurereste und mindestens 80 Mol-%, vorzugsweise mindestens 90 Mol-%, bezogen auf die Diolkomponente, 1,4-Bis(hydroxymethyl)-cyclohexanglykolreste.

Die bevorzugt einzusetzenden und oben genannten Polyester können neben Terephthalsäureresten bis zu 20 Mol-% Reste anderer aromatischer Dicarbonsäuren mit 8 bis 14 C-Atomen oder Reste aliphatischer Dicarbonsäuren mit 4 bis 12 C-Atomen enthalten, bevorzugt Reste von Phthalsäure, Isophthalsäure, Naphthalin-2,6-dicarbonsäure, 4,4'-Diphenyldicarbonsäure, Bernsteinsäure, Adipinsäure, Sebacinsäure, Azelainsäure, Cyclohexandiessigsäure, oder Cyclohexandicarbonsäure.

Die bevorzugt einzusetzenden und oben genannten Polyester können neben Ethylenresten, Butandiol-1,4-glykolresten bzw. 1,4-Bis(hydroxymethyl)-cyclohexanglykolresten bis zu 20 Mol-% andere Reste aliphatischer Diole mit 3 bis 12 C-Atomen oder cycloaliphatischer Diole mit 6 bis 21 C-Atomen enthalten. Bevorzugt sind Reste von Propandiol-1,3, 2-Ethylpropandiol-1,3, Neopentylglykol, Pentan-diol-1,5, Hexandiol-1.6, 3-Methylpentandiol-2,4, 2-Methylpentandiol-2,4, 2,2,4-Trimethylpentandiol-1,3 oder 1,6,2-Ethylhexandiol-1,3, 2,2-Diethylpropandiol-1,3, Hexandiol-2,5, 1,4-Di-(ß-hydroxyethoxy)-benzol, 2,2-Bis-(4-hydroxycyclohexyl)-propan, 2,4-Dihydroxy-1,1,3,3-tetramethyl-cyclobutan, 2,2-Bis-(3-ß-hydroxyethoxyphenyl)-propan oder 2,2-Bis-(4-hydroxypropoxyphenyl)-propan (DE-A 2407674 (= US 4 035 958), DE-A 2407776, DE-A 27 15 932 (=US 4 176 224)).

In einer Ausführungsfom können die bevorzugt einzusetzenden und oben genannten Polyester durch Einbau relativ kleiner Mengen 3- oder 4-wertiger Alkohole oder 3- oder 4-basischer Carbonsäuren, wie sie z.B. in der DE-A 19 00 270 (= US-A 3 692 744) beschrieben sind, verzweigt werden. Bevorzugte Verzweigungsmittel sind Trimesinsäure, Trimellitsäure, Trimethylolethan und Trimethylolpropan und Pentaerythrit.

Die erfindungsgemäß bevorzugt einzusetzenden und oben genannten Polyester besitzen bevorzugt eine intrinsische Viskosität im Bereich von ca. 30 cm³/g bis 150 cm³/g, besonders bevorzugt im Bereich von 40 cm³/g bis 130 cm³/g, insbesondere bevorzugt im Bereich von 50 cm³/g bis 100 cm³/g jeweils gemessen in Phenol/o-Dichlorbenzol (1:1 Gew.-Teile) bei 25°C mittels eines Ubbelohde Viskosimeters.

Erfindungsgemäß einzusetzendes PBT kann beispielsweise von der Lanxess Deutschland GmbH, Köln, Deutschland, unter der Bezeichnung Pocan® B1300 erworben werden.

Erfindungsgemäß einzusetzendes PET kann beispielsweise in Form von Polyester Chips PET V004 von der Firma Invista, Wichita, USA bezogen werden.

Erfindungsgemäß einzusetzendes PCT (CAS No. 24936-69-4) kann beispielsweise von SK Chemicals unter dem Handelsnamen Puratan® bezogen werden. Die als Komponente a) einzusetzenden Polyester können gegebenenfalls auch im Gemisch mit anderen Polyestern und/oder weiteren Polymeren eingesetzt werden.

Als Komponente b) wird Aluminiumsilikat eingesetzt. Bevorzugt wird als Aluminiumsilikat das triklin-pinakoidale Aluminiumsilikat (Al₂SiO₅) eingesetzt, bekannt auch unter der Bezeichnung Kyanit. Kyanit bezeichnet ein Aluminiumsilikat mit spezieller Kristallform, triklin-pinakoidal, und wird auch unter den Namen Cyanit, Disthen oder Sapparit geführt. Die seit 2001 gültige und von der International Mineralogical Association (IMA) verwendete 9. Auflage der Strunz'schen Mineralsystematik ordnet Kyanit in die Klasse "Silikate und Germanate" und dort in die Abteilung der "Inselsilikate (Nesosilikate)"ein. Diese Abteilung ist allerdings weiter unterteilt nach der möglichen Anwesenheit weiterer Anionen sowie der Koordination der beteiligten Kationen, so dass das Mineral entsprechend seiner Zusammensetzung in der Unterabteilung der "Inselsilikate mit zusätzlichem Anionen; Kationen in [4]er, [5]er und/oder nur [6]er-Koordination" zu finden ist, wo es einziges Mitglied der unbenannten Gruppe 9.AF.15 ist. Bevorzugt wird das Aluminiumsilikat, besonders bevorzugt das triklin-pinakoidale Al₂SiO₅, als Pulver eingesetzt. Bevorzugte Pulver weisen eine mittlere Partikelgröße d₅₀ von maximal 500 µm, bevorzugt 0,1 bis 250 µm, besonders bevorzugt 0,5 bis 150 µm, ganz besonders bevorzugt 0,5 bis 70 µm auf (gemäß ASTM D 1921-89, Methode A) wodurch die feine Verteilung im Thermoplasten bzw. in den erfindungsgemäßen Mischungen und thermoplastischen Formmassen gewährleistet wird.

Die erfindungsgemäß zu verwendenden Aluminiumsilikat Partikel, bzw. triklin-pinakoidalen Al₂SiO₅-Partikel, können in unterschiedlichen Formen vorliegen, die durch das Aspektverhältnis beschrieben werden können. Bevorzugt werden Partikel mit einem Aspektverhältnis von 1 bis 100, besonders bevorzugt 1 bis 30, ganz besonders bevorzugt 1 bis 10 eingesetzt.

Die erfindungsgemäß zu verwendenden Aluminiumsilikat Partikel, bevorzugt Al₂SiO₅-Partikel mit triklin-pinakoidaler Kristallstruktur, können mit und ohne Oberflächenmodifizierung eingesetzt werden. Als Oberflächenmodifizierung werden organische Kopplungsmittel bezeichnet, welche die Anbindung an die thermoplastische Matrix verbessern sollen. Als Oberflächenmodifizierung werden bevorzugt Aminosilane, Epoxysilane, Methacrylsilane, Trimethylsilane, Methylsilane oder Vinylsilane, besonders bevorzugt Epoxysilane oder Methacrylsilaneeingesetzt. In einer bevorzugten Ausführungsform werden die erfindungsgemäß zu verwendenden Aluminiumsilikat Partikel, bzw. Al₂SiO₅-Partikel, bzw. Kyanit-Partikel, ohne Oberflächenmodifizierung eingesetzt. Anbieter von Kyanit ist beispielsweise Quarzwerke GmbH, Frechen, Deutschland, die das Kyanit als Al₂SiO₅ unter Silatherm^{®} vertreiben.

Als Komponente c) wird Talkum eingesetzt, bevorzugt mikrokristallines Talkum. Talkum, auch als Talk bezeichnet, ist ein Schichtsilikat mit der chemischen Zusammensetzung Mg₃[Si₄O₁₀(OH)₂], das je nach Modifikation als Talk-1A im triklinen oder als Talk-2M im monoklinen Kristallsystem kristallisiert (http://de.wikipedia.org/wiki/Talkum). Erfindungsgemäß einzusetzendes Talkum kann beispielsweise als Mistron® R10 von Imerys Talc Group, Toulouse, Frankreich (Rio Tinto Group) bezogen werden. Erfindungsgemäß wird unter mikrokristallinem Talkum ein Talkum verstandendessen mittlerer D₅₀-Durchmesser gleich oder kleiner als 4,5 Mikron ist. Es wird vorzugsweise ein mikrokristallines Talkum mit einem D₉₅-Schnittdurchmesser von gleich oder kleiner als 15 Mikron verwendet. Unter "mittlerer D₅₀-Durchmesser" ist ein Durchmesser zu verstehen, bei dem 50 Gew.-% der Partikel eine Größe von weniger als dem genannten Durchmesser haben; unter "D₉₅- Schnittdurchmesser" ist ein Durchmesser zu verstehen, bei dem 95 Gew.-% der Partikel eine Größe von weniger als dem genannten Durchmesser haben. Für nichtsphärische Partikel wird die Größe durch den äquivalenten sphärischen Durchmesser bestimmt (Stokes-Durchmesser). Alle diese D₅₀- und D₉₅-Durchmessermessungen werden mit einer Vorrichtung "Sédigraph" (Warenzeichen) durch Schwerkraftsedimentation gemäß der Norm AFNOR X11-683 durchgeführt. Standard-Talkum besitzt einen D₅₀ in der Größenordnung von 8 bis 15 Mikron.

Als Komponente d) wird bevorzugt wenigstens ein Phosphitstabilisator aus der Gruppe Tris(2,4-ditert-butylphenyl)phosphit (Irgafos® 168, BASF SE, CAS 31570-04-4), Bis(2,4-di-tert-butylphenyl)pentaerythritol-diphosphit (Ultranox® 626, Chemtura ,CAS 26741-53-7), Bis(2,6-di-ter-butyl-4-methylphenyl)pentaerythritol-diphosphit (ADK Stab PEP-36, Adeka, CAS 80693-00-1), Bis(2,4-dicumylphenyl)pentaerythritol-diphosphit (Doverphos® S-9228, Dover Chemical Corporation, CAS 154862-43-8), Tris(nonylphenyl)phosphit (Irgafos® TNPP, BASF SE, CAS 26523-78-4), (2,4,6-tri-t-butylphenol)2-butyl-2-ethyl-1,3-propanediol-phosphit (Ultranox® 641, Chemtura, CAS 161717-32-4) und Tetrakis(2,4-di-tert-butylphenyl)-1,1-biphenyl-4,4'-diylbisphosphonit (Hauptbestandteil des Hostanox® P-EPQ) ausgewählt und eingesetzt.

Insbesondere bevorzugt wird als Phosphitstabilisator wenigstens Hostanox® P-EPQ (CAS No. 119345-01-6) der Clariant International Ltd., Muttenz, Schweiz eingesetzt. Dieses enthält das erfindungsgemäß insbesondere ganz besonders bevorzugt als Komponente d) einzusetzende Tetrakis(2,4-di-tert-butylphenyl)-1,1-biphenyl-4,4'-diylbisphosphonit (CAS No. 38613-77-3).

Das erfindungsgemäß als Komponente e) einzusetzende Additiv zur Verbesserung der Fließfähigkeit wird auch als Fließhilfsmittel, Fließmittel, Fließhilfe oder inneres Gleitmittel bezeichent. Derartige Fließhilfsmittel sind aus der Literatur wie z.B. in Kunststoffe 2000, 90 (9), S. 116-118 bekannt und können bevorzugt Fettsäureester von Polyolen oder Amide aus Fettsäuren und Aminen sein. Alternativ zu den oberflächenaktiven Fließhilfsmitteln können interne Fließhilfsmittel eingesetzt werden, die mit den Polymerharzen verträglich sind. Hierfür eignen sich bevorzugt niedermolekulare Verbindungen oder verzweigte, hochverzweigte oder dendritische Polymere mit einer dem Polymerharz ähnlichen Polarität. Derartige hochverzweigte oder dendritische Systeme sind literaturbekannt und können bevorzugt auf verzweigten Polyestern, Polyamiden, Polyesteramiden, Polyethern oder Polyaminen basieren, wie sie in Kunststoffe 2001, 91 (10), S. 179-190, oder in Advances in Polymer Science 1999, 143 (Branched Polymers II), S. 1-34 beschrieben sind. Besonders bevorzugt werden Copolymerisate von α-Olefinen mit Methacrylsäureestern oder Acrylsäureestern aliphatischer Alkohole verwendet. Sie können beispielsweise von Atofina Deutschland, Düsseldorf unter dem Handelsnamen Lotryl® bezogen werden.

Bevorzugt als Komponente e) einzusetzende Fließhilfsmittel sind Copolymerisate aus mindestens einem α-Olefin mit mindestens einem Methacrylsäureester oder Acrylsäureester eines aliphatischen Alkohols, vorzugsweise eines aliphatischen Alkohols mit 1-30 Kohlenstoffatomen, wobei der MFI (Melt Flow Index) des Copolymerisats 100 g/10 min, vorzugsweise 150 g/10 min, nicht unterschreitet und der MFI (Melt Flow Index) wurde im Rahmen der vorliegenden Erfindung einheitlich bei 190°C und einem Prüfgewicht von 2,16 kg gemessen bzw. bestimmt wird. In einer bevorzugten Ausführungsform enthält das Copolymerisat keine weiteren reaktiven funktionellen Gruppen.

Bevorzugt geeignete α-Olefine als Bestandteil der als Fließhilfsmittel e) einzusetzenden Copolymerisate weisen zwischen 2 und 10 Kohlenstoff-Atomen auf und können unsubstituiert oder mit einer oder mehreren aliphatischen, cycloaliphatischen oder aromatischen Gruppen substituiert sein. Bevorzugte α-Olefine sind ausgewählt aus der Gruppe umfassend Ethen, Propen, 1-Buten, 1-Penten, 1-Hexen, 1-Octen, 3-Methyl-1-penten. Besonders bevorzugte α-Olefine sind Ethen und Propen, ganz besonders bevorzugt ist Ethen. Ebenfalls geeignet sind Mischungen der beschriebenen α□-Olefine.

Der Gehalt des α-Olefins im als Fließhilfsmittel e) einzusetzenden Copolymerisat liegt im Bereich von 50 bis 90 Gew.-%, bevorzugt im Bereich von 55 bis 75 Gew.-% des gesamten Copolymersats.

Das als Komponente e) und Fließhilfsmittel einzusetzende Copolymerisat wird weiterhin definiert durch den zweiten Bestandteil neben dem α-Olefin. Als zweiter Bestandteil sind Alkyl- oder Arylalkylester der Acrylsäure oder Methacrylsäure geeignet, deren Alkyl- oder Arylalkylgruppe aus 1-30 Kohlenstoffatomen gebildet wird und keine oder nur eine geringe Konzentration an reaktiven Funktionen ausgewählt aus der Gruppe umfassend Epoxide, Oxetane, Anhydride, Imide, Aziridine, Furane, Säuren, Amine enthält. Die Alkyl- oder Arylalkylgruppe kann dabei linear oder verzweigt sein sowie cycloaliphatische oder aromatische Gruppen enthalten, daneben auch durch eine oder mehrere Ether- oder Thioetherfunktionen substituiert sein. Bevorzugt geeignete Methacrylsäure- oder Acrylsäureester in diesem Zusammenhang sind auch solche, die aus einer Alkoholkomponente synthetisiert wurden, die auf Oligoethylenglycol oder Oligopropylenglycol mit nur einer Hydroxylgruppe und maximal 30 C-Atomen basieren.

Besonders bevorzugt wird die Alkyl- oder Arylalkylgruppe des Methacrylsäure- oder Acrylsäureesters ausgewählt aus der Gruppe umfassend 1-Pentyl, 1-Hexyl, 2-Hexyl, 3-Hexyl, 1-Heptyl, 3-Heptyl, 1-Octyl, 1-(2-Ethyl)-hexyl, 1-Nonyl, 1-Decyl, 1-Dodecyl, 1-Lauryl oder 1-Octadecyl. Ganz besonders bevorzugt sind Alkyl- oder Arylalkylgruppen mit 6-20 Kohlenstoffatomen. Bevorzugt sind insbesondere auch verzweigte Alkylgruppen, die im Vergleich zu linearen Alkylgruppen gleicher Anzahl an Kohlenstoffatomen zu einer niedrigeren Glasübergangs-Temperatur T_{G} führen.

Erfindungsgemäß insbesondere bevorzugt als Komponente e) einzusetzende Copolymerisate sind solche, bei denen das α-Olefin mit Acrylsäure-(2-ethyl)-hexylester copolymerisiert wird.

Ebenfalls geeignet sind Mischungen der beschriebenen Acrylsäure- oder Methacrylsäurester.

Der Gehalt der Acrylsäure- oder Methacrylsäureester im als Komponente e) einzusetzenden Copolymerisat liegt bevorzugt im Bereich von 10 bis 50 Gew.-%, besonders bevorzugt im Bereich von 25 bis 45 Gew.-% des geamten Copolymerisats.

Als Komponente e) bevorzugt einzusetzende Copolymerisate zeichnen sich neben der Zusammensetzung durch das niedrige Molekulargewicht aus. Dementsprechend sind für die Komponente d) insbesondere Copolymerisate geeignet, die einen MFI-Wert gemessen bei 190°C und einer Belastung von 2,16 kg von mindestens 100 g / 10 min, bevorzugt von mindestens 150 g / 10 min aufweisen.

Erfindungsgemäß wird als Komponente f) wenigstens eine Form von Ruß eingesetzt. Zur Unterscheidung wird für den gezielt hergestellten Industrie-Grundstoff meist der englische Begriff Carbon Black gebraucht, manchmal auch noch der ältere Begriff Industrieruß. Industrieruß ist eine Modifikation des Kohlenstoff mit sehr hoher Oberfläche und wird vor allem als Füllstoff und als Schwarzpigment verwendet. International üblich ist die Klassifizierung von Standardrußen nach der US-amerikanischen ASTM-Norm. Bevorzugt wird Ruß mit einer Partikelgröße im Bereich von 5 und 60 nm, besonders bevorzugt im Bereich von 10 und 40 nm und ganz besonders bevorzugt im Bereich von 15 und 25 nm eingesetzt. Die erfindungsgemäß einzusetzenden Ruße werden bevorzugt als Pulver oder Perlen eingesetzt. Ganz Besonders bevorzugt als Komponente f) einzusetzende Ruße werden ausgewählt aus der Gruppe der ASTM-Normen N220, N234, N294, N330, N326, N347, N440, N472, N539, N550, N568, N601, N660, N762, N770, N785, N880 und N990 (http://de.wikipedia.org/wiki/Ru%C3%9F).Erfindungsgemäß als Komponente f) einzusetzender Ruß wird auch als Schwarz-Pigment (C. I. Pigment Black 7) bezeichnet. Weitere Typen beinhalten Orion Cabot black Pigments (PRINTEX, HIBLACK, AROSPERSE, NIPex, NEROX, COLOUR BLACK, SPECIAL BLACK), oder vom Hersteller Birla Carbon die Typen Raven, Conductex, Copeblack oder vom Hersteller Cabot die Typen BLACK PEARLS, ELFTEX, MOGUL, MONARCH, REGAL,SPHERON, STERLING, VULCAN, CSX, CRX, IRX, UNITED.

Erfindungsgemäß wird als Komponente g) wenigstens ein Entformungsmittel eingesetzt. Als bevorzugte Entformungsmittel wird wenigstens eines ausgewählt aus der Reihe Esterwachs(e), Pentaerytritoltetrastearat (PETS), langkettige Fettsäuren, Salz(e) der langkettigen Fettsäuren, Amidderivat(e) der langkettigen Fettsäuren, Montanwachse sowie niedermolekulare Polyethylen- bzw. Polypropylenwachs(e) oder Ethylen Homopolymer Wachs(e).

Bevorzugte langkettige Fettsäuren sind Stearinsäure oder Behensäure. Bevorzugte Salze langkettiger Fettsäuren sind Calciumstearat oder Zinkstearat. Bevorzugtes Amidderivat langkettiger Fettsäuren ist Ethylen-bis-stearylamid. Bevorzugte Montanwachse sind Mischungen aus geradkettigen, gesättigten Carbonsäuren mit Kettenlängen von 28 bis 32 C-Atomen.

Erfindungsgemäß wird als Komponente h) wenigstens ein Additiv eingesetzt, das sich von den Komponenten b), c), d), e), f) und g) unterscheidet.

Bevorzugte Additive der Komponente h) sind Stabilisatoren, UV-Stabilisatoren, Gammastrahlenstabilisatoren, Antistatika, Fließhilfsmittel, Flammschutzmittel, Elastomermodifikatoren, Brandschutzadditive, Emulgatoren, Nukleierungsmittel, Säurefänger, Weichmacher, Gleitmittel, Farbstoffe oder Pigmente sowie gegebenenfalls zusätzliche von der Komponente b) unterschiedliche Wärmeleitfähigkeitsadditive. Die genannten und weitere geeignete Additive sind zum Beispiel beschrieben in Gächter, Müller, Kunststoff-Additive, 3. Ausgabe, Hanser-Verlag, München, Wien, 1989 und im Plastics Additives Handbook, 5th Edition, Hanser-Verlag, München, 2001. Die Additive können alleine oder in Mischung bzw. in Form von Masterbatchen eingesetzt werden.

Als von Komponente d) unabhängig einzusetzende Stabilisatoren werden bevorzugt sterisch gehinderte Phenole, Hydrochinone, aromatische sekundäre Amine wie Diphenylamine, substituierte Resorcine, Salicylate, Benzotriazole und Benzophenone, sowie verschieden substituierte Vertreter dieser Gruppen oder deren Mischungen eingesetzt.

Als von Komponente f) unabhängig einzusetzende Pigmente bzw. Farbstoffe werden bevorzugt Zinksulfid, Titandioxid, Ultramarinblau, Eisenoxid, Phthalocyanine, Chinacridone, Perylene, Nigrosin und Anthrachinone eingesetzt. Das als Pigment bevorzugt einzusetzende Titandioxid hat bevorzugt eine mittlere Teilchengröße im Bereich von 90 nm bis 2000 nm.

Für das erfindungsgemäß als Pigment bevorzugt einzusetzende Titandioxid kommen Titandioxid-Pigmente in Frage, deren Grundkörper nach dem Sulfat (SP)- oder Chlorid (CP)-Verfahren hergestellt sein können und die Anatas und / oder Rutilstruktur, bevorzugt Rutilstruktur haben. Der Grundkörper muss nicht stabilisiert sein, jedoch ist eine spezielle Stabilisierung bevorzugt: beim CP-Grundkörper durch eine Al- Dotierung von 0,3-3,0 Gew.-% (gerechnet als Al₂O₃) und einen Sauerstoffüberschuss in der Gasphase bei der Oxidation des Titantetrachlorids zu Titandioxid von mindestens 2 % ; beim SP-Grundkörper durch eine Dotierung z. B. mit Al, Sb, Nb oder Zn. Besonders bevorzugt, um eine hinreichend hohe Helligkeit der aus den erfindungsgemäßen Zusammensetzungen herzustellenden Erzeugnisse zu erhalten, ist eine "leichte" Stabilisierung mit Al bevorzugt, bzw. bei höheren Al-Dotierungsmengen eine Kompensation mit Antimon. Bei der Verwendung von Titandioxid als Weißpigment in Farben und Lacken, Kunststoffen usw. ist bekannt, dass durch UV-Absorption erzeugte unerwünschte photokatalytische Reaktionen zur Zersetzung des pigmentierten Materials führen. Dabei absorbieren Titandioxid-Pigmente im nahen ultravioletten Bereich Licht, so dass Elektron-Loch-Paare entstehen, welche hochreaktive Radikale auf der Titandioxid-Oberfläche erzeugen. Die gebildeten Radikale haben in organischen Medien einen Bindemittelabbau zur Folge. Erfindungsgemäß bevorzugt wird zur Erniedrigung der Photoaktivität des Titandioxids dieses anorganisch nachbehandelt, besonders bevorzugt mit Oxiden von Si und / oder Al und / oder Zr und / oder durch den Einsatz von Sn-Verbindungen.

Bevorzugt ist die Oberfläche von pigmentärem Titandioxid mit amorphen Ausfällungen von Oxidhydraten der Verbindungen SiO₂ und / oder Al₂O₃ und / oder Zirkonoxid bedeckt. Die Al₂O₃-Hülle erleichtert die Pigmentdispergierung in der Polymermartrix, die SiO₂-Hülle erschwert den Ladungsaustausch an der Pigmentoberfläche und verhindert dadurch den Polymerabbau.

Erfindungsgemäß wird das Titandioxid bevorzugt mit hydrophilen und/oder hydrophoben organischen Beschichtungen versehen, insbesondere mit Siloxanen oder Polyalkoholen.

Als Nukleierungsmittel, zusätzlich dem unter c) beschriebenen Talkum, werden bevorzugt Natrium- oder Calciumphenylphosphinat, Aluminiumoxid oder Siliziumdioxid eingesetzt

Als Säurefänger werden bevorzugt Hydrotalcit, Kreide, Böhmit oder Zinkstannate eingesetzt.

Als Weichmacher werden bevorzugt Phthalsäuredioctylester, Phthalsäuredibenzylester, Phthalsäurebutylbenzylester, Kohlenwasserstofföle oder N-(n-Butyl)benzolsulfonamid eingesetzt.

Als Elastomermodifikator einzusetzendes Additiv wird bevorzugt eines oder mehrere Pfropfpolymerisat(e) E von
- E.1: 5 bis 95 Gew.-%, vorzugsweise 30 bis 90 Gew.-%, wenigstens eines Vinylmonomeren auf
- E.2: 95 bis 5 Gew.-%, vorzugsweise 70 bis 10 Gew.-% einer oder mehrerer Pfropfgrundlagen mit Glasübergangstemperaturen < 10°C, vorzugsweise < 0°C, besonders bevorzugt <-20°C eingesetzt.

Die Pfropfgrundlage E.2 hat im Allgemeinen eine mittlere Teilchengröße (d₅₀-Wert) von 0,05 bis 10 µm, vorzugsweise 0,1 bis 5 µm, besonders bevorzugt 0,2 bis 1 µm.

Monomere E.1 sind vorzugsweise Gemische aus
- E.1.1: 50 bis 99 Gew.-% Vinylaromaten und/oder kernsubstituierten Vinylaromaten (wie beispielsweise Styrol, α-Methylstyrol, p-Methylstyrol, p-Chlorstyrol) und/oder Methacrylsäure-(C₁-C₈)-Alkylester (wie z.B. Methylmethacrylat, Ethylmethacrylat) und
- E.1.2: 1 bis 50 Gew.-% Vinylcyanide (ungesättigte Nitrile wie Acrylnitril und Methacrylnitril) und/oder (Meth)Acrylsäure-(C₁-C₈)-Alkylester (wie z.B. Methylmethacrylat, n-Butylacrylat, t-Butylacrylat) und/oder Derivate (wie Anhydride und Imide) ungesättigter Carbonsäuren (beispielsweise Maleinsäureanhydrid und N-Phenyl-Maleinimid).

Bevorzugte Monomere E.1.1 sind ausgewählt aus mindestens einem der Monomere Styrol, α-Methylstyrol, Glycidylmethacrylat und Methylmethacrylat, bevorzugte Monomere E.1.2 sind ausgewählt aus mindestens einem der Monomere Acrylnitril, Maleinsäureanhydrid und Methylmethacrylat.

### Besonders bevorzugte Monomere sind E.1.1 Styrol und E.1.2 Acrylnitril.

Für die in den Elastomermodifikatoren einzusetztenden Pfropfpolymerisate geeignete Pfropfgrundlagen E.2 sind beispielsweise Dienkautschuke, EP(D)M-Kautschuke, also solche auf Basis Ethylen/Propylen und gegebenenfalls Dien, Acrylat-, Polyurethan-, Silikon-, Chloropren und Ethylen/Vinylacetat-Kautschuke.

Bevorzugte Pfropfgrundlagen E.2 sind Dienkautschuke (z.B. auf Basis Butadien, Isopren etc.) oder Gemische von Dienkautschuken oder Copolymerisate von Dienkautschuken oder deren Gemischen mit weiteren copolymerisierbaren Monomeren (z.B. gemäß E.1.1 und E.1.2), mit der Maßgabe, dass die Glasübergangstemperatur der Komponente E.2 unterhalb <10°C, vorzugsweise <0°C, besonders bevorzugt <-10°C liegt.

### Besonders bevorzugt ist als Pfropfgrundlage E.2. reiner Polybutadienkautschuk.

Besonders bevorzugte Polymerisate E sind ABS-Polymerisate (Emulsions-, Masse- und Suspensions-ABS), wie sie z. B. in der DE-A 2 035 390 (=US-A 3 644 574) oder in der DE-A 2 248 242 (=GB-A 1 409 275) bzw. in Ullmann, Enzyklopädie der Technischen Chemie, Bd. 19 (1980), S. 280 ff. beschrieben sind. Der Gelanteil der Pfropfgrundlage E.2 beträgt mindestens 30 Gew.-%, vorzugsweise mindestens 40 Gew.-% (in Toluol gemessen). ABS bedeutet Acrylnitril-Butadien-Styrol-Copolymerisat mit der CAS- Nummer 9003-56-9 und ist ein synthetisches Terpolymer aus den drei unterschiedlichen Monomerarten Acrylnitril, 1,3-Butadien und Styrol. Es gehört zu den amorphen Thermoplasten. Die Mengenverhältnisse können dabei variieren von 15-35 % Acrylnitril, 5-30 % Butadien und 40-60 % Styrol.

Die Elastomermodifikatoren bzw. Pfropfcopolymerisate E werden durch radikalische Polymerisation, z.B. durch Emulsions-, Suspensions-, Lösungs- oder Massepolymerisation, vorzugsweise durch Emulsions- oder Massepolymerisation hergestellt.

Besonders geeignete Pfropfkautschuke sind auch ABS-Polymerisate, die durch Redox-Initiierung mit einem Initiatorsystem aus organischem Hydroperoxid und Ascorbinsäure gemäß US-A 4 937 285 hergestellt werden.

Da bei der Pfropfreaktion die Pfropfmonomeren bekanntlich nicht unbedingt vollständig auf die Pfropfgrundlage aufgepfropft werden, werden erfindungsgemäß unter Pfropfpolymerisaten E auch solche Produkte verstanden, die durch (Co)Polymerisation der Pfropfmonomere in Gegenwart der Pfropfgrundlage gewonnen werden und bei der Aufarbeitung mit anfallen.

Geeignete Acrylatkautschuke basieren auf Propfgrundlagen E.2 die vorzugsweise Polymerisate aus Acrylsäurealkylestern, gegebenenfalls mit bis zu 40 Gew.-%, bezogen auf E.2 anderen polymerisierbaren, ethylenisch ungesättigten Monomeren sind. Zu den bevorzugten polymerisierbaren Acrylsäureestern gehören C₁-C₈-Alkylester, bevorzugt Methyl-, Ethyl-, Butyl-, n-Octyl- und 2-Ethylhexylester; Halogenalkylester, vorzugsweise Halogen-C₁-C₈-alkyl-ester, insbesondere bevorzugt Chlorethylacrylat sowie Mischungen dieser Monomeren.

Zur Vernetzung können Monomere mit mehr als einer polymerisierbaren Doppelbindung copolymerisiert werden. Bevorzugte Beispiele für vernetzende Monomere sind Ester ungesättigter Monocarbonsäuren mit 3 bis 8 C-Atomen und ungesättigter einwertiger Alkohole mit 3 bis 12 C-Atomen, oder gesättigter Polyole mit 2 bis 4 OH-Gruppen und 2 bis 20 C-Atomen, wie z.B. Ethylenglykoldimethacrylat, Allylmethacrylat; mehrfach ungesättigte heterocyclische Verbindungen, wie z.B. Trivinyl- und Triallylcyanurat; polyfunktionelle Vinylverbindungen, wie Di- und Trivinylbenzole; aber auch Triallylphosphat und Diallylphthalat.

Bevorzugte vernetzende Monomere sind Allylmethacrylat, Ethylenglykoldimethacrylat, Diallylphthalat und heterocyclische Verbindungen, die mindestens 3 ethylenisch ungesättigte Gruppen aufweisen.

Besonders bevorzugte vernetzende Monomere sind die cyclischen Monomere Triallylcyanurat, Triallylisocyanurat, Triacryloylhexahydro-s-triazin, Triallylbenzole. Die Menge der vernetzten Monomere beträgt vorzugsweise 0,02 bis 5, insbesondere 0,05 bis 2 Gew.-%, bezogen auf die Pfropfgrundlage E.2.

Bei cyclischen vernetzenden Monomeren mit mindestens 3 ethylenisch ungesättigten Gruppen ist es vorteilhaft, die Menge auf unter 1 Gew.-% der Pfropfgrundlage E.2 zu beschränken.

Bevorzugte "andere" polymerisierbare, ethylenisch ungesättigte Monomere, die neben den Acrylsäureestern gegebenenfalls zur Herstellung der Pfropfgrundlage E.2 dienen können, sind beispielsweise Acrylnitril, Styrol, α-Methylstyrol, Acrylamide, Vinyl-C₁-C₆-alkylether, Methylmethacrylat, Butadien. Bevorzugte Acrylatkautschuke als Pfropfgrundlage E.2 sind Emulsionspolymerisate, die einen Gelgehalt von mindestens 60 Gew.-% aufweisen.

Weitere geeignete Pfropfgrundlagen gemäß E.2 sind Silikonkautschuke mit pfropfaktiven Stellen, wie sie in den DE-A 3 704 657 (= US 4 859 740), DE-A 3 704 655 (= US 4 861 831), DE-A 3 631 540 (= US 4 806 593) und DE-A 3 631 539 (= US 4 812 515) beschrieben werden.

Unabhängig von den Komponente b) und c) können als Additive zusätzliche Füll- und/oder Verstärkungsstoffe in den erfindungsgemäßen Zusammensetzungen enthalten sein.

Bevorzugt wird aber auch eine Mischung aus zwei oder mehr unterschiedlichen Füllstoffen und/oder Verstärkungsstoffen, insbesondere auf Basis von Talk, Glimmer, Silikat, Quarz, Titandioxid, Wollastonit, Kaolin, amorphe Kieselsäuren, Magnesiumcarbonat, Kreide, Feldspat, Bariumsulfat, Glasfasern, Glaskugeln und/oder faserförmige Füllstoffe und/oder Verstärkungsstoffen auf der Basis von Kohlenstofffasern eingesetzt. Bevorzugt werden mineralische teilchenförmige Füllstoffe auf der Basis von Glimmer, Silikat, Quarz, Wollastonit, Kaolin, amorphe Kieselsäuren, Magnesiumcarbonat, Kreide, Feldspat oder Bariumsulfat eingesetzt. Besonders bevorzugt werden erfindungsgemäß mineralische teilchenförmige Füllstoffe auf der Basis von Wollastonit oder Kaolin eingesetzt.

Besonders bevorzugt werden ferner auch nadelförmige mineralische Füllstoffe als Additiv eingesetzt. Unter nadelförmigen mineralischen Füllstoffen wird erfindungsgemäß ein mineralischer Füllstoff mit stark ausgeprägtem nadelförmigen Charakter verstanden. Bevorzugt seien nadelförmige Wollastonite genannt. Bevorzugt weist das Mineral ein Länge : Durchmesser - Verhältnis von 2:1 bis 35:1, besonders bevorzugt von 3:1 bis 19:1, am meisten bevorzugt von 4:1 bis 12:1 auf. Die mittlere Teilchengröße der erfindungsgemäßen nadelförmigen Mineralien liegt bevorzugt bei kleiner 20 µm, besonders bevorzugt bei kleiner 15 µm, insbesondere bevorzugt bei kleiner 10 µm bestimmt mit einem CILAS GRANULOMETER.

Wie bereits oben bei der Komponente b) beschrieben, kann in einer bevorzugten Einsatzform der Füllstoff und/oder Verstärkungsstoff oberflächenmodifiziert sein, besonders bevorzugt mit einem Haftvermittler bzw. Haftvermittlersystem, insbesondere bevorzugt auf Epoxidbasis. Die Vorbehandlung ist jedoch nicht unbedingt erforderlich.

In einer besonders bevorzugten Ausführungsform werden als Additiv Glasfasern eingesetzt. Bevorzugte Glasfasern haben einen Faserdurchmesser im Bereich von 7 und 18 µm, besonders bevorzugt im Bereich von 9 und 15 µm, und werden als Endlosfasern oder als geschnittene oder gemahlene Glasfasern zugesetzt. Die Fasern werden bevorzugt mit einem geeigneten Schlichtesystem und einem Haftvermittler bzw. Haftvermittlersystem, besonders bevorzugt auf Silanbasis, ausgerüstet.

Ganz besonders bevorzugte Haftvermittler auf Silanbasis für die Vorbehandlung sind Silanverbindungen der allgemeinen Formel (I)

(X-(CH₂)_{q})k-Si-(O-CrH₂r+1)₄-k (I)

in der die Substituenten folgende Bedeutung haben:
- X:: NH₂-, HO-, 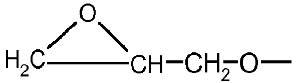
- q:: eine ganze Zahl von 2 bis 10, bevorzugt 3 bis 4,
- r:: eine ganze Zahl von 1 bis 5, bevorzugt 1 bis 2,
- k:: eine ganze Zahl von 1 bis 3, bevorzugt 1.

Insbesondere bevorzugte Haftvermittler sind Silanverbindungen aus der Gruppe Aminopropyltrimethoxysilan, Aminobutyltrimethoxysilan, Aminopropyltriethoxysilan, Aminobutyltriethoxysilan sowie die entsprechenden Silane, welche als Substituent X eine Glycidylgruppe enthalten.

Für die Ausrüstung der Glasfasern werden die Silanverbindungen bevorzugt in Mengen im Bereich von 0,05 bis 2 Gew.-%, besonders bevorzugt im Bereich von 0,25 bis 1,5 Gew.-% und insbesondere im Bereich von 0,5 bis 1 Gew.-% bezogen auf die Glasfasern zur Oberflächenbeschichtung eingesetzt.

Die Glasfasern können bedingt durch die Verarbeitung zur Formmasse bzw. dem daraus herzustellenden Erzeugnis in der Formmasse bzw. im Erzeugnis einen kleineren d97- bzw. d50-Wert aufweisen, als die ursprünglich eingesetzten Glasfasern. Die Glasfasern können bedingt durch die Verarbeitung zur Formmasse bzw. Formkörper in der Formmasse bzw. im Formkörper kürzere Längenverteilungen als ursprünglich eingesetzt aufweisen.

Als zusätzliche, von der Komponente b) unterschiedliche Wärmeleitfähigkeitsadditive, kommen bevorzugt Bornitrid oder Aluminiumnitrid infrage. Bevorzugt beträgt das Verhältnis der Boratome zu den Stickstoffatomen im Bornitrid bzw. das Verhältnis der Aluminiumatome zu den Stickstoffatomen im Aluminiumnitrid größer 1. Besonders bevorzugt liegt das Verhältnis der Boratome zu den Stickstoffatomen im Bornitrid im Bereich von 1,05-1,2. Besonders bevorzugt liegt das Verhältnis der Aluminiumatome zu den Stickstoffatomen im Aluminiumnitrid im Bereich von 1,05-1,25. Besonders bevorzugt liegt die Korngröße des Bornitrids und Aluminiumnitrids im Bereich von 1 µm bis 600 µm.

Die teilchenförmigen Füllstoffe können bedingt durch die Verarbeitung zur Formmasse bzw. Formkörper in der Formmasse bzw. im Formkörper einen kleineren d97- bzw. d50-Wert aufweisen, als die ursprünglich eingesetzten Füllstoffe.

In einer bevorzugten Ausführungsform betrifft die vorliegende Erfindung Zusammensetzungen enthaltend PET, Aluminiumsilikat und wenigstens einen Phosphitstabilisator aus der Gruppe Tris(2,4-ditert-butylphenyl)phosphit, Bis(2,4-di-tert-butylphenyl)pentaerythritol-diphosphit, Bis(2,6-di-ter-butyl-4-methylphenyl)pentaerythritol-diphosphit, Bis(2,4-dicumylphenyl)pentaerythritol-diphosphit, Tris(nonylphenyl)phosphit, (2,4,6-tri-t-butylphenol)2-butyl-2-ethyl-1,3-propanediol-phosphit und Tetrakis(2,4-di-tert-butylphenyl)-1,1-biphenyl-4,4'-diylbisphosphonit. In einer besonders bevorzugten Ausführungsform betrifft die vorliegende Erfindung Zusammensetzungen enthaltend PET, Aluminiumsilikat, Talkum und Tetrakis(2,4-di-tert-butylphenyl)-1,1-biphenyl-4,4'-diylbisphosphonit.

In einer bevorzugten Ausführungsform betrifft die vorliegende Erfindung Zusammensetzungen enthaltend PBT, Aluminiumsilikat und wenigstens einen Phosphitstabilisator aus der Gruppe Tris(2,4-ditert-butylphenyl)phosphit, Bis(2,4-di-tert-butylphenyl)pentaerythritol-diphosphit, Bis(2,6-di-ter-butyl-4-methylphenyl)pentaerythritol-diphosphit, Bis(2,4-dicumylphenyl)pentaerythritol-diphosphit, Tris(nonylphenyl)phosphit, (2,4,6-tri-t-butylphenol)2-butyl-2-ethyl-1,3-propanediol-phosphit und Tetrakis(2,4-di-tert-butylphenyl)-1,1-biphenyl-4,4'-diylbisphosphonit. In einer besonders bevorzugten Ausführungsform betrifft die vorliegende Erfindung Zusammensetzungen enthaltend PBT, Aluminiumsilikat, Talkum und Tetrakis(2,4-di-tert-butylphenyl)-1,1-biphenyl-4,4'-diylbisphosphonit.

In einer bevorzugten Ausführungsform betrifft die vorliegende Erfindung Zusammensetzungen enthaltend PCT, Aluminiumsilikat und wenigstens einen Phosphitstabilisator aus der Gruppe Tris(2,4-ditert-butylphenyl)phosphit, Bis(2,4-di-tert-butylphenyl)pentaerythritol-diphosphit, Bis(2,6-di-ter-butyl-4-methylphenyl)pentaerythritol-diphosphit, Bis(2,4-dicumylphenyl)pentaerythritol-diphosphit, Tris(nonylphenyl)phosphit, (2,4,6-tri-t-butylphenol)2-butyl-2-ethyl-1,3-propanediol-phosphit und Tetrakis(2,4-di-tert-butylphenyl)-1,1-biphenyl-4,4'-diylbisphosphonit. In einer besonders bevorzugten Ausführungsform betrifft die vorliegende Erfindung Zusammensetzungen enthaltend PCT, Aluminiumsilikat, Talkum und Tetrakis(2,4-di-tert-butylphenyl)-1,1-biphenyl-4,4'-diylbisphosphonit.

In einer bevorzugten Ausführungsform betrifft die vorliegende Erfindung Zusammensetzungen enthaltend PET, PBT, Aluminiumsilikat und wenigstens einen Phosphitstabilisator aus der Gruppe Tris(2,4-ditert-butylphenyl)phosphit, Bis(2,4-di-tert-butylphenyl)pentaerythritol-diphosphit, Bis(2,6-di-ter-butyl-4-methylphenyl)pentaerythritol-diphosphit, Bis(2,4-dicumylphenyl)pentaerythritol-diphosphit, Tris(nonylphenyl)phosphit, (2,4,6-tri-t-butylphenol)2-butyl-2-ethyl-1,3-propanediol-phosphit und Tetrakis(2,4-di-tert-butylphenyl)-1,1-biphenyl-4,4'-diylbisphosphonit. In einer besonders bevorzugten Ausführungsform betrifft die vorliegende Erfindung Zusammensetzungen enthaltend PET, PBT, Aluminiumsilikat, Talkum und Tetrakis(2,4-di-tert-butylphenyl)-1,1-biphenyl-4,4'-diylbisphosphonit.

In einer bevorzugten Ausführungsform betrifft die vorliegende Erfindung Zusammensetzungen enthaltend PET, PCT, Aluminiumsilikat und wenigstens einen Phosphitstabilisator aus der Gruppe Tris(2,4-ditert-butylphenyl)phosphit, Bis(2,4-di-tert-butylphenyl)pentaerythritol-diphosphit, Bis(2,6-di-ter-butyl-4-methylphenyl)pentaerythritol-diphosphit, Bis(2,4-dicumylphenyl)pentaerythritol-diphosphit, Tris(nonylphenyl)phosphit, (2,4,6-tri-t-butylphenol)2-butyl-2-ethyl-1,3-propanediol-phosphit und Tetrakis(2,4-di-tert-butylphenyl)-1,1-biphenyl-4,4'-diylbisphosphonit. In einer besonders bevorzugten Ausführungsform betrifft die vorliegende Erfindung Zusammensetzungen enthaltend PET, PCT, Aluminiumsilikat, Talkum und Tetrakis(2,4-di-tert-butylphenyl)-1,1-biphenyl-4,4'-diylbisphosphonit.

In einer bevorzugten Ausführungsform betrifft die vorliegende Erfindung Zusammensetzungen enthaltend PBT, PCT, Aluminiumsilikat und wenigstens einen Phosphitstabilisator aus der Gruppe Tris(2,4-ditert-butylphenyl)phosphit, Bis(2,4-di-tert-butylphenyl)pentaerythritol-diphosphit, Bis(2,6-di-ter-butyl-4-methylphenyl)pentaerythritol-diphosphit, Bis(2,4-dicumylphenyl)pentaerythritol-diphosphit, Tris(nonylphenyl)phosphit, (2,4,6-tri-t-butylphenol)2-butyl-2-ethyl-1,3-propanediol-phosphit und Tetrakis(2,4-di-tert-butylphenyl)-1,1-biphenyl-4,4'-diylbisphosphonit. In einer besonders bevorzugten Ausführungsform betrifft die vorliegende Erfindung Zusammensetzungen enthaltend PBT, PCT Aluminiumsilikat, Talkum und Tetrakis(2,4-di-tert-butylphenyl)-1,1-biphenyl-4,4'-diylbisphosphonit.

In einer bevorzugten Ausführungsform betrifft die vorliegende Erfindung Zusammensetzungen enthaltend PET, Aluminiumsilikat, Talkum und wenigstens einen Phosphitstabilisator aus der Gruppe Tris(2,4-ditert-butylphenyl)phosphit, Bis(2,4-di-tert-butylphenyl)pentaerythritol-diphosphit, Bis(2,6-di-ter-butyl-4-methylphenyl)pentaerythritol-diphosphit, Bis(2,4-dicumylphenyl)pentaerythritol-diphosphit, Tris(nonylphenyl)phosphit, (2,4,6-tri-t-butylphenol)2-butyl-2-ethyl-1,3-propanediol-phosphit und Tetrakis(2,4-di-tert-butylphenyl)-1,1-biphenyl-4,4'-diylbisphosphonit. In einer besonders bevorzugten Ausführungsform betrifft die vorliegende Erfindung Zusammensetzungen enthaltend PET, Aluminiumsilikat, Talkum und Tetrakis(2,4-di-tert-butylphenyl)-1,1-biphenyl-4,4'-diylbisphosphonit.

In einer bevorzugten Ausführungsform betrifft die vorliegende Erfindung Zusammensetzungen enthaltend PBT, Aluminiumsilikat, Talkum und wenigstens einen Phosphitstabilisator aus der Gruppe Tris(2,4-ditert-butylphenyl)phosphit, Bis(2,4-di-tert-butylphenyl)pentaerythritol-diphosphit, Bis(2,6-di-ter-butyl-4-methylphenyl)pentaerythritol-diphosphit, Bis(2,4-dicumylphenyl)pentaerythritol-diphosphit, Tris(nonylphenyl)phosphit, (2,4,6-tri-t-butylphenol)2-butyl-2-ethyl-1,3-propanediol-phosphit und Tetrakis(2,4-di-tert-butylphenyl)-1,1-biphenyl-4,4'-diylbisphosphonit. In einer besonders bevorzugten Ausführungsform betrifft die vorliegende Erfindung Zusammensetzungen enthaltend PBT, Aluminiumsilikat, Talkum und Tetrakis(2,4-di-tert-butylphenyl)-1,1-biphenyl-4,4'-diylbisphosphonit.

In einer bevorzugten Ausführungsform betrifft die vorliegende Erfindung Zusammensetzungen enthaltend PCT, Aluminiumsilikat, Talkum und wenigstens einen Phosphitstabilisator aus der Gruppe Tris(2,4-ditert-butylphenyl)phosphit, Bis(2,4-di-tert-butylphenyl)pentaerythritol-diphosphit, Bis(2,6-di-ter-butyl-4-methylphenyl)pentaerythritol-diphosphit, Bis(2,4-dicumylphenyl)pentaerythritol-diphosphit, Tris(nonylphenyl)phosphit, (2,4,6-tri-t-butylphenol)2-butyl-2-ethyl-1,3-propanediol-phosphit und Tetrakis(2,4-di-tert-butylphenyl)-1,1-biphenyl-4,4'-diylbisphosphonit. In einer besonders bevorzugten Ausführungsform betrifft die vorliegende Erfindung Zusammensetzungen enthaltend PCT, Aluminiumsilikat, Talkum und Tetrakis(2,4-di-tert-butylphenyl)-1,1-biphenyl-4,4'-diylbisphosphonit.

In einer bevorzugten Ausführungsform betrifft die vorliegende Erfindung Zusammensetzungen enthaltend PET, PBT, Aluminiumsilikat, Talkum und wenigstens einen Phosphitstabilisator aus der Gruppe Tris(2,4-ditert-butylphenyl)phosphit, Bis(2,4-di-tert-butylphenyl)pentaerythritol-diphosphit, Bis(2,6-di-ter-butyl-4-methylphenyl)pentaerythritol-diphosphit, Bis(2,4-dicumylphenyl)pentaerythritol-diphosphit, Tris(nonylphenyl)phosphit, (2,4,6-tri-t-butylphenol)2-butyl-2-ethyl-1,3-propanediol-phosphit und Tetrakis(2,4-di-tert-butylphenyl)-1,1-biphenyl-4,4'-diylbis-phosphonit. In einer besonders bevorzugten Ausführungsform betrifft die vorliegende Erfindung Zusammensetzungen enthaltend PET, PBT, Aluminiumsilikat, Talkum und Tetrakis(2,4-di-tert-butylphenyl)-1,1-biphenyl-4,4'-diylbisphosphonit.

In einer bevorzugten Ausführungsform betrifft die vorliegende Erfindung Zusammensetzungen enthaltend PET, PCT, Aluminiumsilikat, Talkum und wenigstens einen Phosphitstabilisator aus der Gruppe Tris(2,4-ditert-butylphenyl)phosphit, Bis(2,4-di-tert-butylphenyl)pentaerythritoldiphosphit, Bis(2,6-di-ter-butyl-4-methylphenyl)pentaerythritol-diphosphit, Bis(2,4-dicumylphenyl)pentaerythritol-diphosphit, Tris(nonylphenyl)phosphit, (2,4,6-tri-t-butylphenol)2-butyl-2-ethyl-1,3-propanediol-phosphit und Tetrakis(2,4-di-tert-butylphenyl)-1,1-biphenyl-4,4'-diylbisphosphonit. In einer besonders bevorzugten Ausführungsform betrifft die vorliegende Erfindung Zusammensetzungen enthaltend PET, PCT, Aluminiumsilikat, Talkum und Tetrakis(2,4-di-tert-butylphenyl)-1,1-biphenyl-4,4'-diylbisphosphonit.

In einer bevorzugten Ausführungsform betrifft die vorliegende Erfindung Zusammensetzungen enthaltend PBT, PCT, Aluminiumsilikat, Talkum und wenigstens einen Phosphitstabilisator aus der Gruppe Tris(2,4-ditert-butylphenyl)phosphit, Bis(2,4-di-tert-butylphenyl)pentaerythritol-diphosphit, Bis(2,6-di-ter-butyl-4-methylphenyl)pentaerythritol-diphosphit, Bis(2,4-dicumylphenyl)pentaerythritol-diphosphit, Tris(nonylphenyl)phosphit, (2,4,6-tri-t-butylphenol)2-butyl-2-ethyl-1,3-propanediol-phosphit und Tetrakis(2,4-di-tert-butylphenyl)-1,1-biphenyl-4,4'-diylbisphosphonit. In einer besonders bevorzugten Ausführungsform betrifft die vorliegende Erfindung Zusammensetzungen enthaltend PBT, PCT Aluminiumsilikat, Talkum und Tetrakis(2,4-di-tert-butylphenyl)-1,1-biphenyl-4,4'-diylbisphosphonit.

In einer bevorzugten Ausführungsform betrifft die vorliegende Erfindung Zusammensetzungen enthaltend PET, PBT, PCT, Aluminiumsilikat, Talkum und wenigstens einen Phosphitstabilisator aus der Gruppe Tris(2,4-ditert-butylphenyl)phosphit, Bis(2,4-di-tert-butylphenyl)pentaerythritol-diphosphit, Bis(2,6-di-ter-butyl-4-methylphenyl)pentaerythritol-diphosphit, Bis(2,4-dicumylphenyl)pentaerythritol-diphosphit, Tris(nonylphenyl)phosphit, (2,4,6-tri-t-butylphenol)2-butyl-2-ethyl-1,3-propanediol-phosphit und Tetrakis(2,4-di-tert-butylphenyl)-1,1-biphenyl-4,4'-diylbisphosphonit. In einer besonders bevorzugten Ausführungsform betrifft die vorliegende Erfindung Zusammensetzungen enthaltend PET, PBT, PCT, Aluminiumsilikat, Talkum und Tetrakis(2,4-di-tert-butylphenyl)-1,1-biphenyl-4,4'-diylbisphosphonit.

Die vorliegende Erfindung betrifft aber auch die Verwendung von Alumiumsilikat, bevorzugt vom als Kyanit bezeichneten triklin-pinakoidalen Aluminiumsilikat Al₂SiO₅, zur Herstellung elektrisch isolierender, thermisch leitfähiger Erzeugnisse, bevorzugt von Kühlkörpern, insbesondere von Kühlkörpern für Licht emittierende Dioden (LEDs).

Die vorliegende Erfindung betrifft aber auch die Verwendung von Alumiumsilikat, bevorzugt vom als Kyanit bezeichneten triklin-pinakoidalen Aluminiumsilikat Al₂SiO₅, in Kombination mit Talkum zur Herstellung elektrisch isolierender, thermisch leitfähiger Erzeugnisse, bevorzugt von Kühlkörpern, insbesondere von Kühlkörpern für Licht emittierende Dioden (LEDs).

Die vorliegende Erfindung betrifft aber auch die Verwendung von Alumiumsilikat, bevorzugt vom als Kyanit bezeichneten triklin-pinakoidalen Aluminiumsilikat Al₂SiO₅, zur Herstellung elektrisch isolierender, thermisch leitfähiger, Polyester basierter Erzeugnisse, bevorzugt von Polyester basierten Kühlkörpern, insbesondere von Polyester basierten Kühlkörpern für Licht emittierende Dioden (LEDs).

Hierfür werden die erfindungsgemäßen Zusammensetzungen in Form von Formmassen einem Spritzguss oder einer Extrusion unterzogen um daraus elektrisch isolierende, thermisch leitfähige Erzeugnisse bevorzugt Kühlkörper, insbesondere Kühlkörper für Licht emittierende Dioden (LEDs), insbesondere auf Basis von Polyester herzustellen.

Zur Herstellung erfindungsgemäß für den Spritzguss oder für die Extrusion einzusetzende Formmassen erhält man, indem man die einzelnen Komponenten der erfindungsgemäßen Zusammensetzungen vermischt, zu einem Strang austrägt, bis zur Granulierfähigkeit abkühlt und granuliert. Bevorzugt erfolgt das Vermischen bei Temperaturen im Bereich von 285 bis 310°C in der Schmelze. Insbesondere bevorzugt wird hierzu ein Zweiwellenextruder eingesetzt. In einer bevorzugten Ausführungsform wird das Granulat, das die erfindungsgemäße Zusammensetzung enthält, bei 120°C im Vakuumtrockenschrank für ca. 2h getrocknet, bevor es dem Spritzguss oder einem Extrusionsverfahren zwecks Herstellung von Erzeugnissen unterzogen wird.

Die vorliegende Erfindung betrifft aber auch ein Verfahren zur Herstellung von Erzeugnissen, bevorzugt elektrisch isolierender, thermisch leitfähiger Erzeugnisse, bevorzugt von Kühlkörpern, insbesondere von Kühlkörpern für Licht emittierende Dioden (LEDs), indem das Matrixmaterial als Formmasse enthaltend die erfindungsgemäßen Zusammensetzungen durch Spritzguss oder Extrusion, bevorzugt durch Spritzguss erhalten wird.

Die vorliegende Erfindung betrifft aber auch ein Verfahren zur Verbesserung der Wärmeleitfäigkeit Polyester-basierter Erzeugnisse, dadurch gekennzeichnet, dass man erfindungsgemäße Zusammensetzungen in Form von Formmassen durch Spritzguss oder Extrusion verarbeitet.

Die Verfahren des Spritzgusses sowie der Extrusion thermoplastischer Formmassen sind dem Fachmann bekannt.

Erfindungsgemäße Verfahren zur Herstellung von Erzeugnissen durch Extrusion oder Spritzguss arbeiten bei Schmelzetemperaturen im Bereich von 230 bis 330°C, bevorzugt von 250 bis 300°C sowie gegebenenfalls zusätzlich bei Drücken von maximal 2500 bar, bevorzugt bei Drücken von maximal 2000 bar, besonders bevorzugt bei Drücken von maximal 1500 bar und ganz besonders bevorzugt bei Drücken von maximal 750 bar.

Bei der sequentiellen Coextrusion werden zwei unterschiedliche Materialien in alternierender Folge hintereinander ausgestoßen. Auf diese Weise entsteht ein Vorformling mit in Extrusionsrichtung abschnittsweise unterschiedlicher Materialzusammensetzung. Es können bestimmte Artikelabschnitte durch entsprechende Materialauswahl mit spezifisch erforderlichen Eigenschaften ausgestattet werden, beispielsweise für Artikel mit weichen Enden und hartem Mittelteil oder integrierten weichen Faltenbalg-Bereichen (Thielen, Hartwig, Gust, "Blasformen von Kunststoffhohlkörpern", Carl Hanser Verlag, München 2006, Seite 127-129).

Das Verfahren des Spritzgusses zeichnet sich dadurch aus, dass der Rohstoff, bevorzugt in Granulatform, in einem beheizten zylindrischen Hohlraum aufgeschmolzen (plastifiziert) und als Spritzmasse unter Druck in einen temperierten Hohlraum gespritzt wird. Nach dem Abkühlen (Erstarren) der Masse wird das Spritzgussteil entformt.

### Man unterscheidet

1. Plastifizieren / Aufschmelzen
2. Einspritzphase (Füllvorgang)
3. Nachdruckphase (wegen thermischer Kontraktion bei der Kristallisation)
4. Entformen.

Eine Spritzgießmaschine besteht aus einer Schließeinheit, der Spritzeinheit, dem Antrieb und der Steuerung. Zur Schließeinheit gehören feste und bewegliche Aufspannplatten für das Werkzeug, eine Stirnplatte sowie Säulen und Antrieb der beweglichen Werkzeugaufspannplatte. (Kniehebelgelenk oder hydraulische Schließeinheit).

Eine Spritzeinheit umfasst den elektrisch beheizbaren Zylinder, den Antrieb der Schnecke (Motor, Getriebe) und die Hydraulik zum Verschieben der Schnecke und Spritzeinheit. Die Aufgabe der Spritzeinheit besteht darin, das Pulver bzw. das Granulat aufzuschmelzen, zu dosieren, einzuspritzen und nachzudrücken (wegen Kontraktion). Das Problem des Rückflusses der Schmelze innerhalb der Schnecke (Leckströmung) wird durch Rückstromsperren gelöst.

Im Spritzgießwerkzeug wird dann die einströmende Schmelze gelöst, gekühlt und somit das zu fertigende Erzeugnis gefertigt. Notwendig dazu sind immer zwei Werkzeughälften. Beim Spritzguss unterscheidet man folgende Funktionskomplexe:
- Angusssystem
- Formbildende Einsätze
- Entlüftung
- Maschinen- und Kraftaufnahme
- Entformungssystem und Bewegungsübertragung
- Temperierung

Im Gegensatz zum Spritzguss wird bei der Extrusion ein endlos geformter Kunststoffstrang, im Extruder eingesetzt, wobei der Extruder eine Maschine zur Herstellung thermoplastischer Formstücke ist. Man unterscheidet

Einschneckenextruder und Doppelschneckenextruder sowie die jeweiligen Untergruppen
konventioneller Einschneckenextruder, förderwirksamer Einschneckenextruder,
gegenläufiger Doppelschneckenextruder und gleichläufiger Doppelschneckenextruder.

Extrusionsanlagen bestehen aus Extruder, Werkzeug, Nachfolgeeinrichtung, Extrusionsblasformen. Extrusionsanlagen zum Herstellen von Profilen bestehen aus: Extruder, Profil-Werkzeug, Kalibrierung, Kühlstrecke, Raupen- und Rollenabzug, Trennvorrichtung und Kipprinne.

Die vorliegende Erfindung betrifft folglich auch Erzeugnisse, insbesondere wärmeleitfähige Erzeugnisse, erhältlich durch Extrusion, Profil-Extrusion oder Spritzguss der erfindungsgemäßen Zusammensetzungen.

Die vorliegende Erfindung betrifft bevorzugt ein Verfahren zur Herstellung von Erzeugnissen, bevorzugt wärmeleitfähiger Erzeugnisse, dadurch gekennzeichnet, dass man oben genannte Zusammensetzungen, bevorzugt Zusammensetzungen enthaltend
a) 15 bis 70 Gew.-%, bevorzugt 15 bis 50 Gew.-%, besonders bevorzugt 20 bis 40 Gew.-%, wenigstens eines Polyesters, bevorzugt PBT, PET oder PCT oder Blends aus beliebigen Kombinationen dieser, besonders bevorzugt Blends aus PBT und PET, worin der Anteil an PET bezogen auf die Summe aller enthaltenen Polyester im Bereich von 50 bis 99,9 Gew-% liegt,
b) 29 bis 84 Gew.-% Aluminiumsilikat, bevorzugt 45 bis 80 Gew.-% Aluminiumsilikat, besonders bevorzugt 55 bis 75 Gew.-% Aluminiumsilikat, und gegebenenfalls
c) 0,01 bis 15 Gew.-%, bevorzugt 0,01 bis 10 Gew.-%, besonders bevorzugt 0,01 bis 5 Gew.-% Talkum, bevorzugt mikrokristallines Talkum, wobei die Summe aller Gewichtsprozente stets 100 ergibt, zu Formmassen verarbeitet und diese einem Spritzguss oder einer Extrusion unterzieht.

Die auf erfindungsgemäße Weise hergestellten Erzeugnisse eignen sich hervorragend zur Herstellung elektrisch isolierender, thermisch leitfähiger Erzeugnisse, bevorzugt von Kühlkörpern, insbesondere von Kühlkörpern für Licht emittierende Dioden (LEDs).

### Beispiele:

**Edukte:** PBT: Polybutylenterephthalat Pocan® B1300 der Lanxess Deutschland GmbH, Köln, Deutschland unter der Bezeichnung
PET: Polyester Chips PET V004 von der Firma Invista, Wichita, USA
Phosphitstabilisator: Hostanox® P-EPQ der Clariant International Ltd., Muttenz, Schweiz
Talkum: Mistron® R10 von Imerys Talc Group, Toulouse, Frankreich (Rio Tinto Group)
Entformungsmittel: Licowax® E der Clariant International Ltd., Muttenz, Schweiz
Kyanit: Al₂SiO₅-Partikel Silatherm® mit Epoxysilanbeschlichtung, Quarzwerke GmbH, Frechen, Deutschland.
Aluminiumoxid: Martoxid® MDS der Albermale Corp. Baton Rouge, Louisiana, USA
Bornitrid: Boronid TCP015FK von ESK, Kempten, Deutschland

### Versuchsdurchführung:

Zur Herstellung der erfindungemäß beschriebenen Zusammensetzungen wurden die einzelnen Komponenten in einem Zweiwellenextruder (ZSK 26 Mega Compounder der Fa. Coperion Werner & Pfleiderer (Stuttgart, Deutschland mit 3-Loch Düsenplatte und einem Düsenlochdurchmesser von 3mm) bei Temperaturen zwischen 280 und 295°C in der Schmelze vermischt, als Strang ausgetragen, bis zur Granulierfähigkeit abgekühlt und granuliert. Vor weiteren Schritten wurde das Granulat bei 120°C im Vakuumtrockenschrank für ca. 2h getrocknet.

Die Platten und Prüfkörper für die in der Tabelle 1 und Tabelle 2 aufgeführten Untersuchungen wurden auf einer handelsüblichen Spritzgießmaschine bei einer Massetemperatur von 280-290°C und einer Werkzeugtemperatur von 80-120°C verspritzt.

### Messung der Schlagzähigkeit:

Die Schlagzähigkeit (Einheit kJ/m²) der aus den erfindungsgemäßen thermoplastischen Formmassen hergestellten Erzeugnisse wurden im Schlagversuch nach ISO 180-1 U bei 23°C bestimmt.

### Messung der Randfaserdehnung:

Die Randfaserdehnung (Einheit %) der aus den erfindungsgemäßen thermoplastischen Formmassen hergestellten Erzeugnisse wurden im Biegeversuch nach ISO5 178-A bei 23 °C bestimmt.

### Messung der Wärmeleitfähigkeit:

Die Wärmeleitfähigkeit wurde an Platten mit den Maßen 12,7 mm · 12,7 mm · 2 mm nach ISO 22007-4 bestimmt.

**Tabelle 1:**

| | Bsp 1 | Vgl 1 | Vgl 2 |
|---|---|---|---|
| PBT | 49,5 | 49,5 | 49,5 |
| Aluminiumsilikat | 50 | | |
| Aluminiumoxid | | 50 | |
| Bornitrid | | | 50 |
| Entformungsmittel | 0,3 | 0,3 | 0,3 |
| Phosphitstabilisator | 0,1 | 0,1 | 0,1 |
| Talkum | 0,1 | 0,1 | 0,1 |
| | | | |
| Schlagzähigkeit | 36 | 9 | 27 |
| Randfaserdehnung | 3,4 | 1,0 | 3,0 |

Wie aus Tabelle 1 (Bsp. = erfindungsgemäßes Beispiel; Vgl. = Vergleichsbeispiel gemäß dem Stand der Technik) ersichtlich, werden für Erzeugnisse auf Basis der erfindungsgemäßen Zusammensetzungen unter Einsatz von Aluminiumsilikat bei gleichem Füllgrad deutlich bessere mechanische Eigenschaften, insbesondere im Vergleich zu Bornitrid, erhalten. Für einen Vergleich der Wärmeleitfähigkeiten bei höheren Füllgraden wurden deshalb erfindungsgemäße Erzeugnisse nur mit Aluminiumoxid enthaltenden Erzeugnissen verglichen. (Tabelle 2).

**Tabelle 2:**

| | Bsp 2 | Vgl 3 |
|---|---|---|
| PBT | 34,5 | 34,5 |
| Aluminiumsilikat | 65 | |
| Aluminiumoxid | | 65 |
| Entformungsmittel | 0,3 | 0,3 |
| Phosphitstabilisator | 0,1 | 0,1 |
| Talkum | 0,1 | 0,1 |
| | | |
| Schlagzähigkeit [W/mK] | 18 | 10 |
| Wärmeleitfähigkeit [KJ/m2] | 1,0 | 0,7 |

Der Vergleich von Bsp. 2 und Vgl. 3 zeigt, dass bei Probekörpern erhältlich aus Formmassen erfindungsgemäßer Zusammensetzungen im Vergleich zu Probekörpern aus Formmassen enthaltend Zusammensetzungen mit Aluminiumoxid sowohl bessere Wärmeleitfähigkeiten als auch bessere Schlagzähigkeiten erhalten werden können.

## Patentansprüche

1. Zusammensetzungen enthaltend
a) 15 bis 70 Gew.-% wenigstens eines Polyesters,
b) 29 bis 84 Gew.-% Aluminiumsilikat und gegebenenfalls
c) 0,01 bis 15 Gew.-% Talkum, wobei die Summe aller Gewichtsprozente stets 100 ergibt.

2. Zusammensetzungen gemäß Anspruch 1, **dadurch gekennzeichnet, dass** diese zusätzlich zu den Komponenten a) bis c) noch
d) 0,01 bis 5 Gew.-% wenigstens eines Phosphitstabilisators enthalten, wobei die Komponenten a, b, c) soweit reduziert werden, dass die Summe aller Gewichtsprozente stets 100 ergibt.

3. Zusammensetzungen gemäß Anspruch 1 oder 2, **dadurch gekennzeichnet, dass** diese zusätzlich zu den Komponenten a) bis d) oder anstelle von d) noch
e) 0,01 bis 10 Gew.% wenigstens eines Additives zur Verbesserung der Fließfähigkeit enthalten, wobei die übrigen Komponenten soweit reduziert werden, dass die Summe aller Gewichtsprozente stets 100 ergibt.

4. Zusammensetzungen gemäß einem der Ansprüche 1 bis 3, **dadurch gekennzeichnet, dass** diese zusätzlich zu den Komponenten a) bis d) oder anstelle von d) und/oder e) noch
f) 0,01 bis 5 Gew.-% wenigstens einer Form von Ruß enthalten, wobei die übrigen Komponenten soweit reduziert werden, dass die Summe aller Gewichtsprozente stets 100 ergibt.

5. Zusammensetzungen gemäß einem der Ansprüche 1 bis 4, **dadurch gekennzeichnet, dass** diese zusätzlich zu den Komponenten a) bis e) oder anstelle der Komponenten d) und/oder e) und/oder f) noch
g) 0,01 bis 15 Gew.-% wenigstens eines Entformungsmittels enthalten, wobei die übrigen Komponenten soweit reduziert werden, dass die Summe aller Gewichtsprozente stets 100 ergibt.

6. Zusammensetzungen gemäß einem der Asnprüche 1 bis 5, **dadurch gekennzeichnet, dass** diese zusätzlich zu den Komponenten a) bis g) oder anstelle der Komponenten d) und/oder e) und/oder f) und/oder g) noch
h) 0,01 bis 45 Gew.-% wenigstens eines sonstigen, zu den Komponenten c) bis g) unterschiedlichen Additivs enthalten, wobei die übrigen Komponenten soweit reduziert werden, dass die Summe aller Gewichtsprozente stets 100 ergibt.

7. Zusammensetzungen gemäß Anspruch 6, **dadurch gekennzeichnet, dass** als Additiv Glasfasern eingesetzt werden.

8. Zusammensetzungen gemäß einem der Ansprüche 2 bis 7, **dadurch gekennzeichnet, dass** als Phosphitstabilisator wenigstens einer aus der Gruppe Tris(2,4-ditert-butylphenyl)phosphit, Bis(2,4-di-tert-butylphenyl)pentaerythritol-diphosphit, Bis(2,6-di-ter-butyl-4-methylphenyl)pentaerythritol-diphosphit, Bis(2,4-dicumylphenyl)pentaerythritol-diphosphit, Tris(nonylphenyl)phosphit, (2,4,6-tri-t-butylphenol)2-butyl-2-ethyl-1,3-propanediol-phosphit und Tetrakis(2,4-di-tert-butylphenyl)-1,1-biphenyl-4,4'-diylbisphosphonit eingesetzt wird.

9. Zusammensetzungen gemäß einem der Ansprüche 1 bis 8, **dadurch gekennzeichnet, dass** als Aluminiumsilikat triklin-pinakoidales Aluminiumsilikat Al₂SiO₅ eingesetzt wird.

10. Zusammensetzungen gemäß einem der Ansprüche 1 bis 9, **dadurch gekennzeichnet, dass** als Polyester wenigstens ein Polyalkylenterephthalat oder Polycycloalkylenterephthalat, bevorzugt wenigstens ein Polyester der Gruppe Polybutylenterephthalat (PBT), Polyethylenterephthalat (PET), Poly(1,4-cyclohexandimethanolterephthalat (PCT), oder ein Blend auf Basis von PBT und PET, oder ein Blend auf Basis von PBT und PCT, oder ein Blend auf Basis von PET und PCT oder ein Blend auf Basis von PBT, PET und PCT eingesetzt wird.

11. Verwendung von Alumiumsilikat zur Herstellung thermisch leitfähiger Erzeugnisse.

12. Verwendung gemäß Anspruch 11, **dadurch gekennzeichnet, dass** als Aluminiumsilikat triklin-pinakoidales Aluminiumsilikat Al₂SiO₅ eingesetzt wird.

13. Verwendung gemäß einem der Ansprüche 11 oder 12, **dadurch gekennzeichnet, dass** das Aluminiumsilikat in Kombination mit Talkum eingesetzt wird.

14. Verwendung gemäß einem der Ansprüche 11 bis 13, **dadurch gekennzeichnet, dass** es sich um Polyester basierte Erzeugnisse handelt.

15. Verfahren zur Herstellung von Erzeugnissen, **dadurch gekennzeichnet, dass** man Zusammensetzungen gemäß einem der Ansprüche 1 bis 10 zu Formmassen verarbeitet und diese einem Spritzguss oder einer Extrusion unterzieht.
